# EUROPEAN PATENT SPECIFICATION

(11) **EP 0 879 489 B1**
(45) Date of publication and mention of the grant of the patent: **15.03.2000**
(21) Application number: 96941764.1
(22) Date of filing: 11.12.1996
(51) Int. Cl.: H01R 12/08

(54) **CIRCUIT BOARD CLIP CONNECTOR**
RASTVERBINDER FÜR LEITERPLATTE
CONNECTEUR A CRAMPON POUR CARTE A CIRCUIT IMPRIME

(30) Priority: 05.02.1996 US 596841
(43) Date of publication of application: 25.11.1998
(73) Proprietor: Ford Motor Company, Dearborn, MI 48126 (US); FORD MOTOR COMPANY LIMITED, Brentwood, Essex CM13 3BW (GB)
(72) Inventor: TODD, Michael, P., South Lyon, MI 48178 (US); GLOVATSKY, Andrew, Z., Ypsilanti, MI 48198 (US); SINKUNAS, Peter, J., Canton, MI 48187 (US)
(74) Representative: Messulam, Alec Moses
(86) International application number: PCT/GB96/03050
(87) International publication number: WO 97/29526

(56) References cited:
- DE-A- 4 136 204
- US-A- 5 306 162

## Description

This invention relates to forming electrical connections.

It is known to connect printed copper conductors formed on a substrate with other electrical conductors. Prior technology used a connector which was attached to the circuit board or a moulded interconnect device. Also, it is known to connect electrical components such as capacitors, integrated circuits and resistors to electrical conductor runs on a substrate. Such connections can be made using heat and solder. There are disadvantages to using heat and solder because of the time, cost, and possible damage to components that such a procedure may cause.

It also known to use mechanical compression to form electrical connections. However, with mechanical compression there is the difficulty of providing a uniform force and insuring that there is sufficient pressure to make the electrical connection and have it reliably function under various operating conditions such as vibration and temperature changes.

An electrical connection assembly of this kind is known from DE-A 41 36 204 which includes a releasable connector, a flexible circuit having a first shape with parallel stripes of conductor, a circuit board having a second shape with parallel stripes of conductor, and attachment means for attaching said connector to said circuit board, the conductors on the circuit board being aligned with and facing the conductors on the flexible circuit and said first and second shapes being adapted to generally conform to each other and said connector having a shape suitable for applying pressure between the flexible circuit and the circuit board, said connector having an elongate body with pressure points extending from it towards said flexible circuit and aligned with said stripes of conductor so as to concentrate the pressure on said stripes of conductor, said circuit board further including openings for receiving the attachment means and said flexible circuit and said circuit board having aligned openings therein for receiving alignment pins extending from said connector. In this assembly the connector is a separate component and is attached to the circuit board by screws at each end of the body.

It would be desirable to have a mechanical connection which provides sufficient pressure in a form which is more easily assembled and provides a reliable compression force.

According to the invention, such a connection is provided by an electrical connection assembly as set forth in claim 1.

The clip connector of the invention eliminates the need for soldering to substrates or for a conventional connector and its associated cost, and as it is moulded as part of a larger plastic assembly there is substantially no incremental cost for the connector when moulded from vestige.

The invention will now be described further, by way of example, with reference to the accompanying drawings, in which:
Figure 1 is a side view of a clip connector in accordance with an embodiment to this invention;
Figure 2 is a plan view of a flexible circuit with electrical conductors for receiving the clip connector;
Figure 3 is a side view of the clip connector and receiving substrate in an unmated condition;
Figure 4 is a side view of the clip connector and the substrate in a mated condition; and
Figure 5 is a perspective view of the clip connector and receiving substrate in an unmated condition.

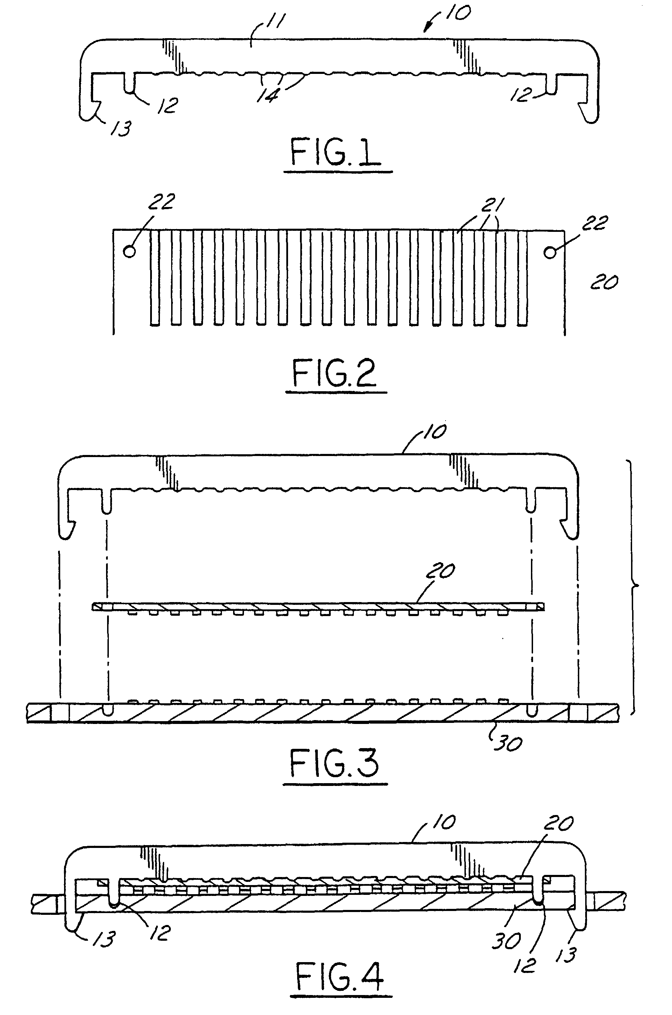

Referring to Figure 1, a snap latch 10 includes an elongate main body 11 having at each end a guide pin 12 and a latching arm 13. Along main body 11 on the same side as guide pins 12 are a plurality of pressure points 14 which are sufficiently rigid to apply pressure to an electrical conductor to insure an electrical connection. The distance between the ends of main body 11 is advantageously less than 15 cms (6 inches) so that a substantially uniform pressure is applied along the length of main body 11. Main body 11 need not be planar and can include a curvilinear portion. Such a curvilinear portion would be adapted to mate with conductors mounted on a similar curvilinear surface.

Referring to Figure 2, a flexible circuit 20 has a plurality of electrical conductors 21 positioned to be aligned with pressure points 14. Guide holes 22 are positioned at either end of the plurality of electrical conductors 21 and receive guide pins 12. The edge of flexible substrate 20 is such that latches 13 can snap around it and secure latch 10 to circuit 20.

Advantageously, the spacing between latches 13 is sufficiently small so that main body 11 does not flex to the point where insufficient pressure is applied by pressure points 14 to conductors 21. A typical material for clamp 10 is an engineering thermoplastic polymer, such as, but not limited to, acrylonitrile-butadiene-styrene copolymer (ABS), polypropylene, polystyrene, polyetherimide, polyethersulfone, or a thermosetting polymer, such as, but not limited to phenol-formaldehyde, polyurethane, or epoxy. All such systems may employ filler materials to advantageously increase modulus of the materials and decrease susceptibility to creep.

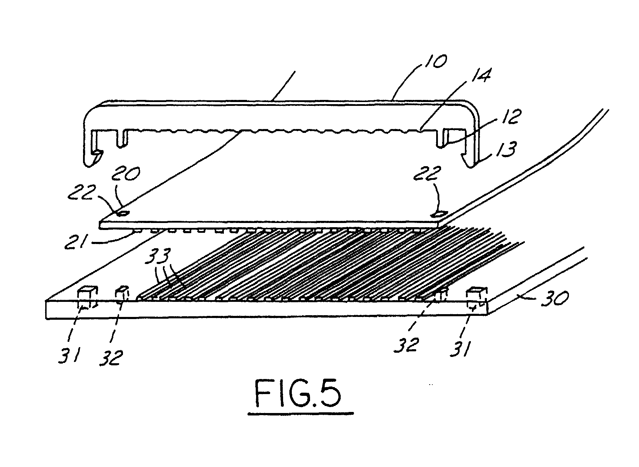

Referring to Figures 3, 4, and 5, clip connector 10 is attached to a circuit board 30 which has pressure clip receiving openings 31 for receiving pressure latch clips 13. Circuit board 30 also has a pair of spaced alignment openings 32 for receiving alignment pin 12 as it passes through alignment opening 22 of the flex circuit 20. The copper conductors 21 of flex circuit 20 are aligned with copper conductors 33 of circuit board 30 and also with pressure points 14 of clip connector 10. As a result, a quick efficient assembly procedure can be used to produce reliable electrical connections without the use of heat. Advantageously, the spacing of the clip connector 10 when seated and circuit board 30 is such that there is in the preferred case, approximately 35-700 kPa (5-100 psi) of pressure applied by pressure points 14 to conductors 21 of flex circuit 20 and conductors 33 of circuit board 30.

## Claims

1. An electrical connection assembly including a releasable connector (10), a flexible circuit (20) having a first shape with parallel stripes (21) of conductor, a circuit board (30) having a second shape with parallel stripes (33) of conductor, and attachment means (13) for attaching said connector to said circuit board, the conductors (33) on the circuit board (30) being aligned with and facing the conductors (21) on the flexible circuit (20) and said first and second shapes being adapted to generally conform to each other and said connector (10) having a shape suitable for applying pressure between the flexible circuit (20) and the circuit board (30),
- said connector (10) having an elongate body (11) with pressure points (14) extending from it towards said flexible circuit and aligned with said stripes of conductor so as to concentrate the pressure on said stripes of conductor,
- said circuit board (30) further including openings (31) for receiving the attachment means (13) and said flexible circuit (20) and said circuit board (30) having aligned openings therein for receiving alignment pins (12) extending from said connector (10),
characterised in that
- the connector (10) is a part which has been integrally moulded with the circuit board and includes latching arms (13) extending from each end of the connector body (11) and constituting the attachment means, said latching arms being aligned with said receiving openings (31) in the circuit board and passing through and engaging therewith to apply pressure between the parts of the assembly.

2. An electrical connector assembly according to claim 1, wherein the connector body (11) includes a curvilinear portion adapted to mate with conductors mounted on a similar curvilinear surface.

## Patentansprüche

1. Elektrische Anschlußeinheit mit einem lösbaren Verbinder (10), einer flexiblen Schaltung (20) mit einer ersten Form mit parallelen Leiterstreifen (21), einer Leiterplatte (30) mit einer zweiten Form mit parallelen Leiterstreifen (33), und mit Befestigungsmitteln (13) zur Befestigung des besagten Verbinders an besagter Leiterplatte, wobei die Leiter (33) auf der Leiterplatte (30) mit den gegenüberliegenden Leitern (21) auf der flexiblen Schaltung (20) fluchten und besagte erste und zweite Formen so ausgelegt sind, daß sie im wesentlichen an einander angepaßt sind, und wobei besagter Verbinder (10) eine Form aufweist, die geeignet ist, Druck zwischen der flexiblen Schaltung (20) und der Leiterplatte (30) auszuüben,
- wobei besagter Verbinder (10) einen länglichen Körper (11) mit Druckpunkten (14) aufweist, die sich von ihm weg zu besagter flexibler Schaltung erstrecken und mit besagten Leiterstreifen fluchten, so daß der Druck auf besagte Leiterstreifen konzentriert wird,
- wobei besagte Leiterplatte (30) außerdem Öffnungen (31) zur Aufnahme der Befestigungsmittel (13) aufweist, und wobei in besagter flexibler Schaltung (20) und besagter Leiterplatte (30) miteinander fluchtende Öffnungen zur Aufnahme von sich von besagtem Verbinder (10) aus erstreckenden Ausrichtstiften (12) befinden,
dadurch gekennzeichnet, daß
- der Verbinder (10) ein Teil ist, welches einteilig mit der Leiterplatte gegossen wurde und Rastarme (13) aufweist, die sich von jedem Ende des Verbinderkörpers (11) aus erstrecken und die Befestigungsmittel bilden, wobei besagte Rastarme mit besagten Aufnahmeöffnungen (31) in der Leiterplatte fluchten und diese durchdringen und damit in Eingriff treten, so daß zwischen den Teilen der Einheit Druck ausgeübt wird.

2. Elektrische Anschlußeinheit nach Anspruch 1, worin der Verbinderkörper (11) einen gebogenen Abschnitt aufweist, der ausgelegt ist, sich an auf einer ähnlich gebogenen Fläche angebrachte Leiter anzupassen.

## Revendications

1. Ensemble de connexion électrique comprenant un connecteur amovible (10), un circuit souple (20) présentant une première forme comportant des bandes parallèles (21) de conducteur, une carte de circuit (30) présentant une seconde forme comportant des bandes parallèles (33) de conducteur, et un moyen de fixation (13) destiné à fixer ledit connecteur à ladite carte de circuit, les conducteurs (33) sur la carte de circuit (30) étant alignés avec les conducteurs (21) sur le circuit souple (20) et en regard de ceux-ci, et lesdites première et seconde formes étant conçues de façon à correspondre pratiquement l'une à l'autre, et ledit connecteur (10) présentant une forme appropriée pour appliquer une pression entre le circuit souple (20) et la carte de circuit (30),
- ledit connecteur (10) comportant un corps allongé (11) présentant des points de pression (14) s'étendant à partir de celui-ci en direction dudit circuit souple et alignés avec lesdites bandes de conducteur de manière à concentrer la pression sur lesdites bandes de conducteur,
- ladite carte de circuit (30) comprenant en outre des ouvertures (31) destinées à recevoir le moyen de fixation (13), et ledit circuit souple (20) et ladite carte de circuit (30) comportant des ouvertures alignées dans ceux-ci destinées à recevoir des broches d'alignement (12) s'étendant à partir dudit connecteur (10),
caractérisé en ce que
- le connecteur (10) est une pièce qui a été moulée de façon intégrée avec la carte de circuit et comprend des bras de verrouillage (13) s'étendant à partir de chaque extrémité du corps (11) du connecteur et constituant le moyen de fixation, lesdits bras de verrouillage étant alignés avec lesdites ouvertures de réception (31) dans la carte de circuit et passant à travers celles-ci et venant en prise avec celles-ci afin d'appliquer une pression entre les parties de l'ensemble.

2. Ensemble de connecteur électrique selon la revendication 1, dans lequel le corps de connecteur (11) comprend une partie curviligne conçue pour s'accoupler avec des conducteurs montés sur une surface curviligne similaire.
